# EUROPEAN PATENT SPECIFICATION

(11) **EP 3 005 341 B1**
(45) Date of publication and mention of the grant of the patent: **19.08.2020**
(21) Application number: 14800939.2
(22) Date of filing: 27.05.2014
(51) Int. Cl.: G09G 3/36, G06F 3/038, H03K 19/00, H03K 19/0185

(54) **LEVEL SHIFTER FOR A LIQUID CRYSTAL DISPLAY**
PEGELSCHIEBER FÜR EINE FLÜSSIGKRISTALLANZEIGE
DISPOSITIF DE CHANGEMENT DE NIVEAU POUR ÉCRAN À CRISTAUX LIQUIDES

(30) Priority: 24.05.2013 US 201361827464 P; 19.12.2013 US 201314135092
(43) Date of publication of application: 13.04.2016
(73) Proprietor: Texas Instruments Incorporated, Dallas, TX 75265-5474 (US); Texas Instruments Deutschland GmbH, 85356 Freising (DE)
(72) Inventor: REITHMAIER, Stefan, A., 84186 Vilsheim (DE); BERNARD, Josy, 85356 Freising (DE); STOERK, Carsten, I., 85354 Freising (DE); GUIBOURG, Nicolas, M., 80801 Munich (DE)
(74) Representative: Zeller, Andreas
(86) International application number: PCT/US2014/039564
(87) International publication number: WO 2014/190347

(56) References cited:
- US-A1- 2004 041 763
- US-A1- 2008 297 676
- US-A1- 2011 012 822
- US-A1- 2011 169 723
- US-A1- 2011 193 839
- US-B2- 7 817 172

## Description

This relates in general to electronic circuitry, and in particular to a level shifter for a liquid crystal display (LCD).

### BACKGROUND

LCDs are widely used in computer monitors, laptop computers, tablet computers, cellular telephones, video players, cameras, watches and television sets, as well as other devices. In one example, LCDs are small in size, light in weight, low in power consumption and able to produce high-resolution images. LCDs are often in the form of display panels having row and column address lines coupled to pattern generator electronics, which generate patterns or video on the display. The voltage for driving the LCD is often much greater than the voltage handling capacity of the pattern generator electronics. Accordingly, a level shifter between the pattern generator electronics and the display is useful to convert lower voltage signals from the pattern generator electronics to the voltage for driving the display.

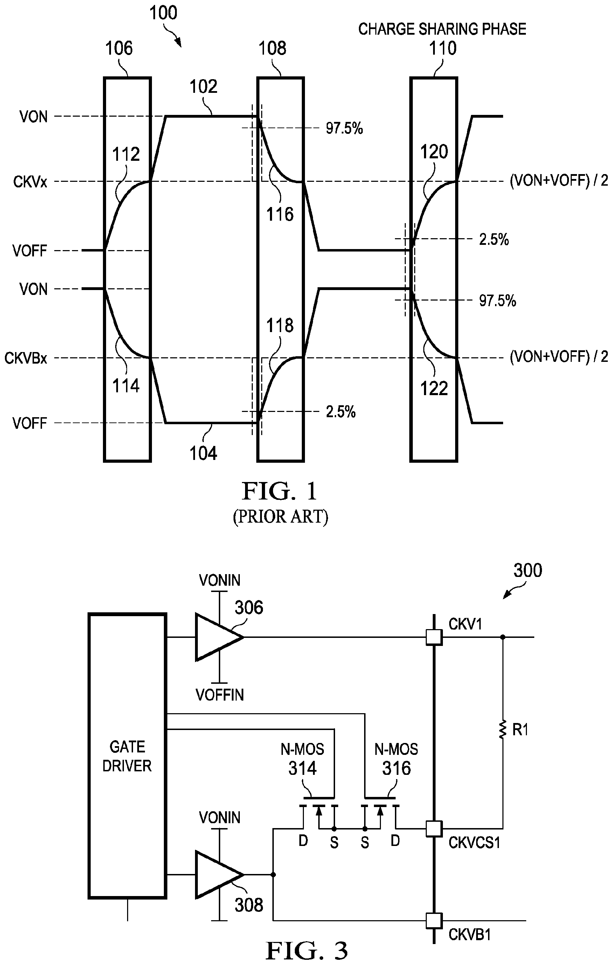

The display's row lines can be modeled as a capacitor in series with a resistor. The power for charging the capacitive load is a significant portion of the power for driving the display. Accordingly, this charge is sharable between a first row line and a second row line, which are operated out of phase with each other. This charge sharing phase is shown in FIG. 1 generally as 100. The two clock signals 102 and 104 are 180° out of phase with each other, and they share charge during the time periods shown in rectangles 106, 108 and 110. In rectangle 106, charging occurs at 112, and discharging occurs at 114. In rectangle 108, discharging occurs at 116, and charging occurs at 118. In rectangle 110, charging occurs at 120, and discharging occurs at 122

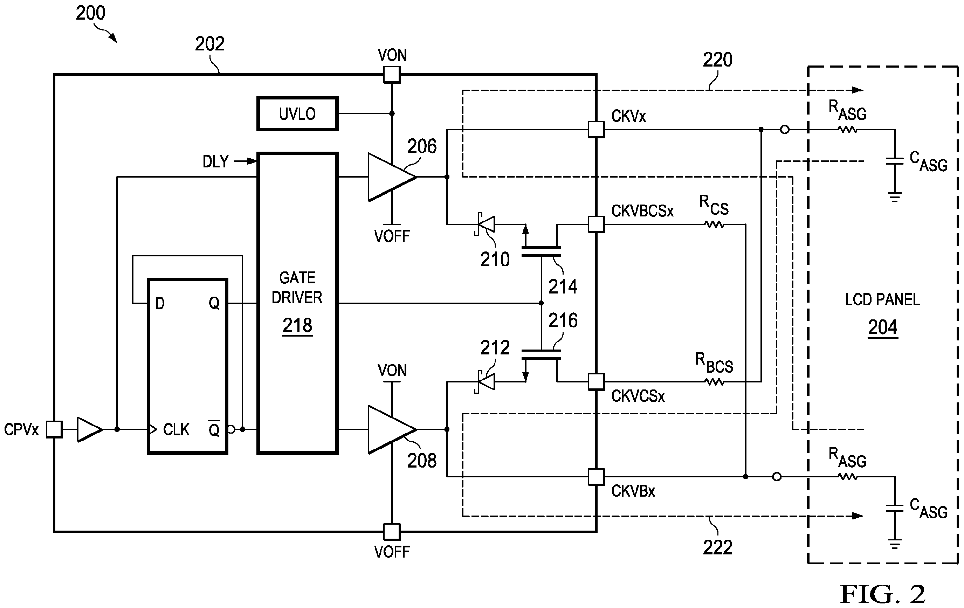

FIG. 2 shows a prior art LCD system 200 having an LCD panel 204 and a driving circuit 202. The driving circuit 202 includes circuitry for performing the charge sharing shown in FIG. 1. In FIG. 2, each of the row lines of the LCD panel 204 is modeled as a resistor R_{ASG} in series with a capacitor C_{ASG}. Circuit 202 includes a gate driver circuit 218 for driving buffers 206 and 208 and for providing a signal to charge transfer transistors 214 and 216. Diodes 210 and 212 prevent reverse current flow. When activated, transistor 214 allows current to flow as shown by dotted lines 220. When activated, transistor 216 allows current to flow as shown by dotted lines 222. Resistors R_{CS} and our R_{BCS} control the slope of the charge/discharge in order to reduce visual effects on the LCD panel. One disadvantage of this circuit is two pins or balls for each channel.

FIG. 3 shows a prior art circuit 300, which uses transistors 314, 316 in place of the diodes 210 and 212 of FIG 2, and which allows the use of a single resistor R1 in place of the two resistors R_{CS} and R_{BCS} of FIG. 2.

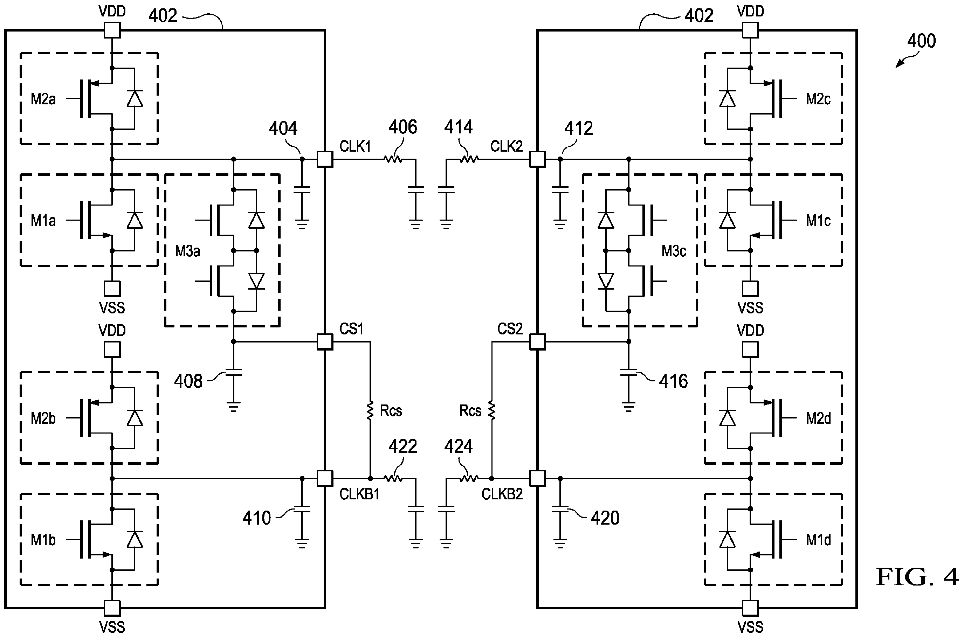

FIG. 4 shows a prior art circuit 400 for driving four row lines or channels. For clarity, the integrated circuit 402 is shown divided into a left side circuit and a right side circuit. In one example, a single integrated circuit includes both the left side circuit and the right side circuit. This circuit uses the single resistor charge sharing technique of FIG. 3. The row lines 406, 414, 422 and 424 are each modeled as a resistor in series with a capacitor to ground. The driver circuit for row 406 includes a push-pull driver circuit, which includes transistors M1a and M2a coupled between VDD and VSS and having an output coupled to channel CLK1. Transistors M3a correspond to the transistors 314 and 316 of FIG.3, which replace the diodes 210 and 212 of FIG. 2. Parasitic capacitor 404 is present at pin CLK1, and parasitic capacitor 408 is present at pin CS1. These parasitic capacitors are a result of electrostatic discharge (ESD) circuits at those pins, as well as the parasitic capacitances of the transistors M3a.

Similarly, the driver circuit for row 422 includes a push-pull driver circuit, which includes transistors M1b and M2b coupled between VDD and VSS and having an output coupled to channel CLKB1. Parasitic capacitance 410 is present on pin CLKB1. The driver circuit for row 414 includes a push-pull driver circuit, which includes transistors M1c and M2c coupled between VDD and VSS and having an output coupled to channel CLK2. Transistors M3c correspond to the transistors 314 and 316 of FIG.3, which replace the diodes 210 and 212 of FIG. 2. Parasitic capacitor 412 is present at pin CLK2, and parasitic capacitor 416 is present at pin CS2. These parasitic capacitors are a result of ESD circuits at those pins, as well as the parasitic capacitances of the transistors M3c. The driver circuit for row 424 includes a push-pull driver circuit, which includes transistors M1d and M2d coupled between VDD and VSS and having an output coupled to channel CLKB2. Parasitic capacitor 420 is present at pin CLKB2.

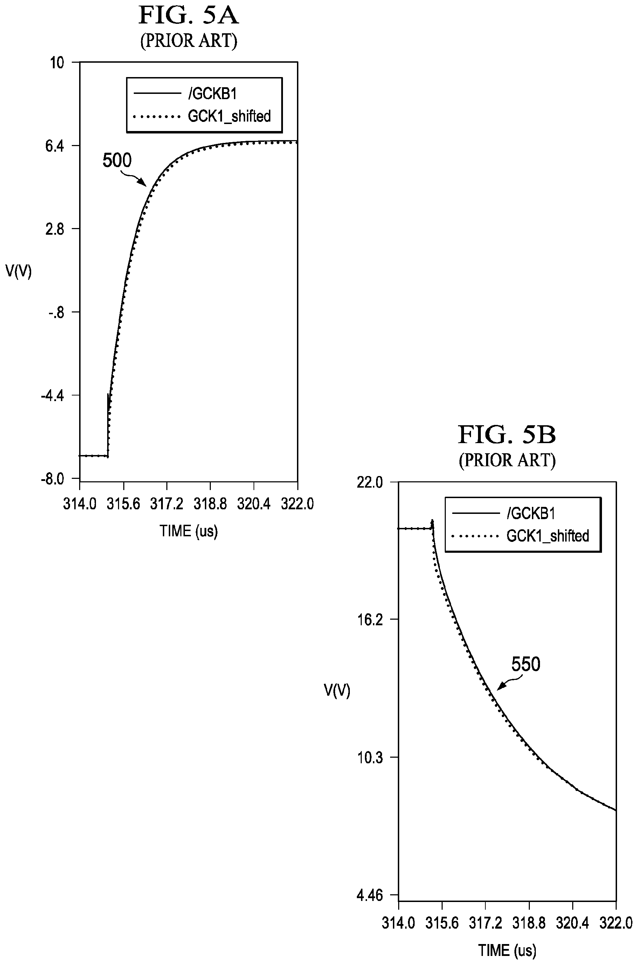

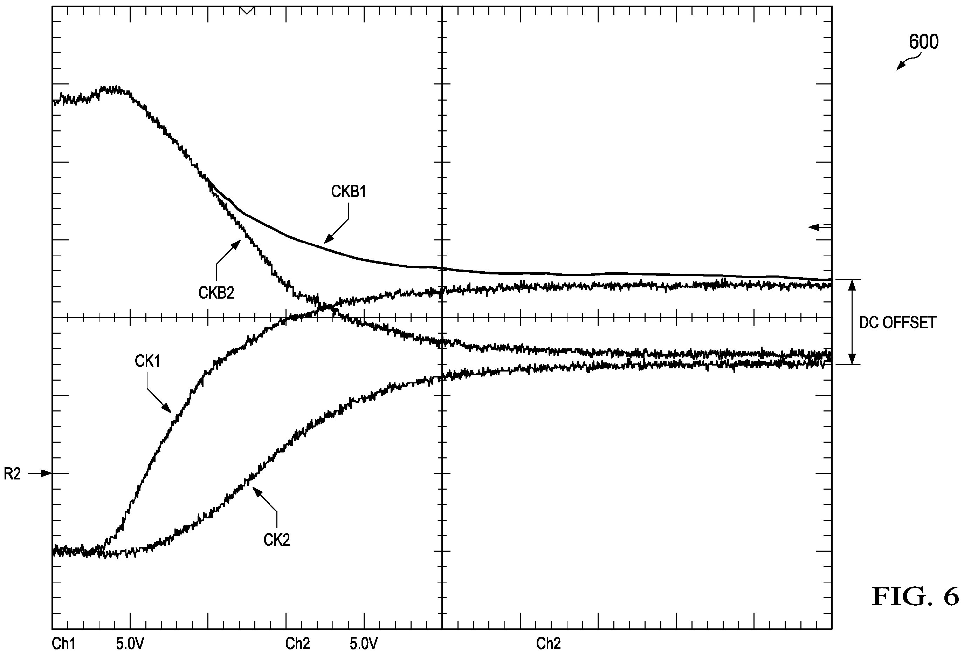

This circuit allows the resistors R_{CS} to be shared between a channel pair [RS1] and reduces the pin count. However, this circuit creates a problem for the latest LCDs, because driving channel 406 (for example) includes the effects of the parasitic capacitance 408, but driving line 422 does not include this parasitic capacitance. A similar situation exists when sharing charge between the two row lines. Accordingly, slope of the charging (rising) waveform (FIG. 5A) is different from slope of the discharging (falling) waveform (FIG. 5B). This difference in slopes creates a DC offset as shown in graph 600 of FIG. 6. The DC offset is shown at the right side of the waveform. This may create objectionable visual effects on the latest LCDs. Moreover, although resistors are shared between two channels, different resistors (normally discrete components) are used for each pair of channels. Different resistances of these shared resistors may cause differences in the slope during charge sharing, which may create objectionable visual effects on the display.

US2004041763 A1 discloses a driving circuit for an active-matrix liquid-crystal display that short-circuits at least two of the signal lines in the matrix at times of transitions of signal-line potentials in the matrix. Charge stored in the parasitic capacitances of the signal lines is thereby recycled from one signal line to another, reducing the current consumption of the driving circuit. When alternating-current driving is employed, current consumption can also be reduced by reducing the frequency with which signal lines are driven from one side of a center potential to the other side.

US2011169723 A1 discloses a level shift circuit that includes a control logic circuit, a plurality of level shift output buffers and a plurality of charge sharing circuits. The control logic circuit receives input clock pulse signals and a charge sharing signal and acquires voltage level information of each received signal. Each output buffer amplifies a corresponding input clock pulse signal and determines whether to output a signal according to the acquired information of the charge sharing signal. Each charge sharing circuit determines whether to be turned on according to the acquired information of a corresponding input clock pulse signal. When a charge sharing circuit is turned on, the output terminal of a corresponding output buffer and a predetermined voltage level are coupled to each other by the charge sharing circuit, so as to perform the charge sharing operation. Furthermore, a corresponding liquid crystal display device and a corresponding charge sharing method are also provided.

### SUMMARY

The invention is defined in the independent claims.

In a first embodiment, a level shifter circuit has a plurality of channels for providing signals to a capacitive load and has circuits for sharing charge stored in the capacitive load between the channels. A first pair of channel clock generating circuits are coupled respectively to a first pair of channels. A second pair of channel clock generating circuits are coupled respectively to a second pair of channels. A first pair of switches couples the first pair of channels together, and a second pair of switches couples the second pair of channels together, for sharing charge between the channels. A single resistor is coupled in circuit with all of the channels for controlling a slope of charge sharing between the channels.

In a second embodiment, a level shifter for an LCD includes a first row line control circuit that controls a first row line of the LCD. A second row line control circuit controls a second row line of the LCD. A third row line control circuit controls a third row line of the LCD. A fourth row line control circuit controls a fourth row line of the LCD. A first switch is coupled to the first and second row line control circuits for sharing charge stored on the first row line with the second row line. A second switch is coupled to the third row line control circuit and the fourth row line control circuit for sharing charge stored on the third row line with the fourth row line. A single resistor is coupled between the first switch and the second row line control circuit and coupled between the second switch and the fourth row line control circuit. The slope of charge and discharge voltages on the row lines are substantially identical.

In a third embodiment, an LCD includes an LCD panel that has pixels arranged in rows and columns. A level shifter circuit is coupled to at least four row lines of the LCD panel. The level shifter shifts the voltage level of signals generated by a display pattern generator circuit to control the row lines of the LCD panel. A plurality of switches are each coupled between a pair of row lines for sharing charge stored on one row line with a second row line through a single resistor.

### BRIEF DESCRIPTION OF THE DRAWINGS

FIG. 1 is a timing diagram of charge sharing between channels of an LCD.
FIG. 2 is a schematic diagram of a prior art circuit for charge sharing between channels.
FIG. 3 is a schematic diagram of a prior art circuit for charge sharing between channels using a shared resistor.
FIG. 4 is a schematic diagram of a prior art circuit for charge sharing between four channels using two shared resistors.
FIG. 5A is a graph of a rising (charging) signal.
FIG. 5B is a graph of a falling (discharging) signal for charge sharing between channels.
FIG. 6 is a graph of a DC offset generated by differences in slope between the signals of FIGS. 5A and 5B.
FIG. 7 is a schematic diagram of a level shifter circuit of one embodiment.
FIG. 8A is a graph of a falling (discharging) signal of a pair of channels.
FIG. 8B is a graph of a rising (charging) signal of a pair of channels for the circuit of FIG. 7.
FIG. 9 is a timing diagram of drive signals for four channels of an LCD having the charge sharing characteristics of the circuit of FIG. 7.

### DETAILED DESCRIPTION OF EXAMPLE EMBODIMENTS

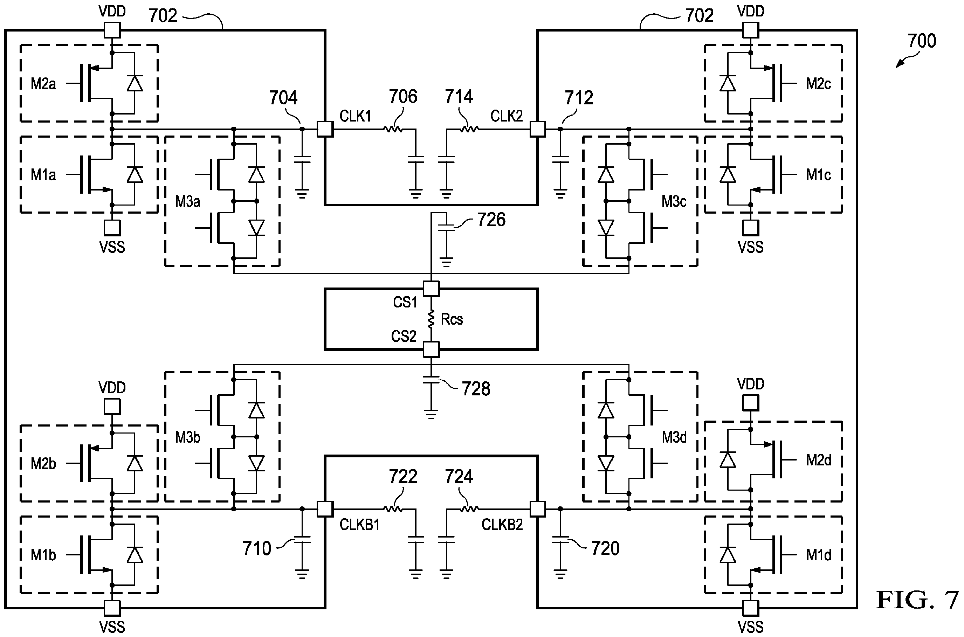

FIG. 7 shows a level shifter circuit 700 of one embodiment. An integrated circuit portion 702 is shown with an "H" configuration for clarity, but it can be implemented in other shapes and sizes appropriate for an integrated circuit. The portion 702 drives four rows or channels 706, 722, 714 and 724 of LCD. As shown in FIG. 7, each of the rows or channels is modeled as a resistor in series with a capacitor.

Row 706 is driven by a push-pull driver circuit, which includes transistor M2a in series with transistor M1a and coupled between VDD and VSS. The output of the push-pull driver circuit is taken between the two transistors and coupled to pin CLK1, which is coupled to the row 706. A parasitic capacitance 704 is present at pin CLK1. Also, transistors M3a (corresponding to transistors M3a of FIG. 4) are coupled to pin CLK1. The other terminal of the transistors M3a is connected to pin CS1 as shown in FIG. 4. A parasitic capacitance 726 is present at pin CS1, similar to the parasitic capacitance 408 shown in FIG. 4.

A second row or channel CLKB1 is driven by a push-pull driver circuit, which includes transistor M2b in series with transistor M1b and coupled between VDD and VSS. The output of the push-pull driver circuit is taken between the two transistors and coupled to pin CLKB1, which is coupled to the row 722. A parasitic capacitance 710 is present at pin CLKB1. Unlike the circuit shown in FIG. 4, the pin CLKB1 is coupled via transistors M3b to pin CS2. The transistors M3b are similar to the transistors M3a discussed above. A parasitic capacitance 728 is present at pin CS2.

Similarly to the drive for row 706, row 714 is driven by a push-pull driver circuit, which includes transistor M2c in series with transistor M1c and coupled between VDD and VSS. The output of the push-pull driver circuit is taken between the two transistors and coupled to pin CLK1, which is coupled to the row 706. A parasitic capacitance 712 is present at pin CLK2. Also, transistors M3c (corresponding to transistors M3c of FIG. 4) are coupled to pin CLK2. Unlike the circuit shown in FIG. 4, the other terminal of the transistors M3c is connected to pin CS1.

Similarly to the drive for row 722, a third row or channel CLKB2 is driven by a push-pull driver circuit, which includes transistor M2d in series with transistor M1d and coupled between VDD and VSS. The output of the push-pull driver circuit is taken between the two transistors and coupled to pin CLKB2, which is coupled to the row 724. A parasitic capacitance 720 is present at pin CLKB2. Unlike the circuit shown in FIG. 4, the pin CLKB2 is coupled via transistors M3d to pin CS2. The transistors M3d are similar to the transistors M3a discussed above.

A single resistor R_{CS} is coupled between the pins CS1 and CS2 and serves as the resistance to control the slope of the charge and discharge of the capacitances for the row lines for all four rows or channels of FIG. 7. In one version of the embodiment, the resistor R_{CS} is the only component of circuit 700 external to portion 702, so criticality of the resistor R_{CS} is has been reduced.

In operation, each of the rows or channels is operated from a different phase of a clock signal, so that no two drivers are operating concurrently. For example, during one phase, charge may be transferred from the capacitor in row 706 via pin CLK1 through transistors M3a, pin CS1, resistor R_{CS}, pin CS2, transistors M3b and pin CLKB1 into the capacitor for row 722. In a second phase, charge flowing from the capacitor in row 722 would follow the opposite path for charging the capacitor in row 706. Also, for example, in a third phase, charge flowing from the capacitor in row 714 would flow through pin CLK2, transistors M3c, pin CS1, resistor R_{CS}, pin CS2, transistors M3d and pin CLKB2, into the capacitor for row 724. In a fourth phase, charge flowing from the capacitor in row 724 would follow the opposite path for charging the capacitor in row 714. Other patterns of the charge/discharge cycle can be used as long as only one channel is active at a time.

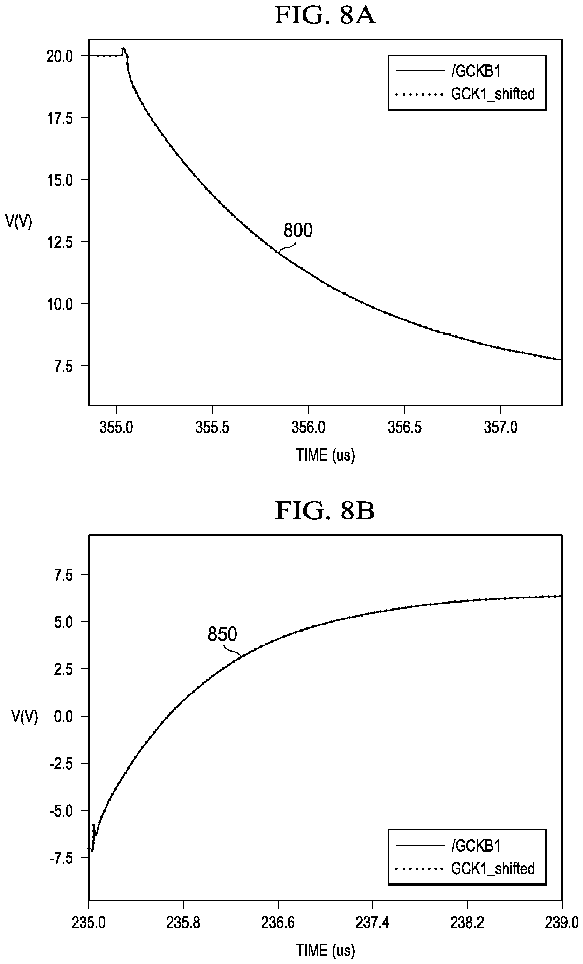

The charge and discharge paths between the rows are identical for each pair of row drivers. Further, on an integrated circuit, the values of the parasitic capacitances at the various pins will be substantially the same, which assures that the charge and discharge paths between all of the rows is essentially the same. This is shown in FIG. 8A, which shows the discharge waveform 800 of two channels, phase shifted so they are in time alignment. Waveform 800 appears to be a single waveform, but it is actually the waveforms for two channels superimposed on each other. Accordingly, the two discharge cycles are substantially identical. Similarly, the waveform 850 in FIG. 8B shows the charging waveform 850 of two channels, with the waveforms time shifted so they are superimposed upon each other.

The waveform 850 appears to be a single waveform, but it is actually two identical waveforms superimposed upon each other. Accordingly, identity of the charge and discharge waveform is shown, and the visual effects produced by the circuit of FIG. 4 are substantially reduced.

Moreover, all of the charge/discharge paths use the same resistor R_{CS}. Accordingly, the time constant for all the channels will be substantially identical, and the criticality of this component selection has been removed. Also, the same resistor can be used for additional pairs of channels, which saves pins or solder bumps on the integrated circuit, and which reduces the cost of the integrated circuit. Although a circuit using four channels is shown in FIG. 7, the circuit can be expanded to other configurations by adding pairs of channels, but only a single resistor is needed. For example, the circuit can include 6, 8, 10, etc. channels using a single resistor R_{CS}.

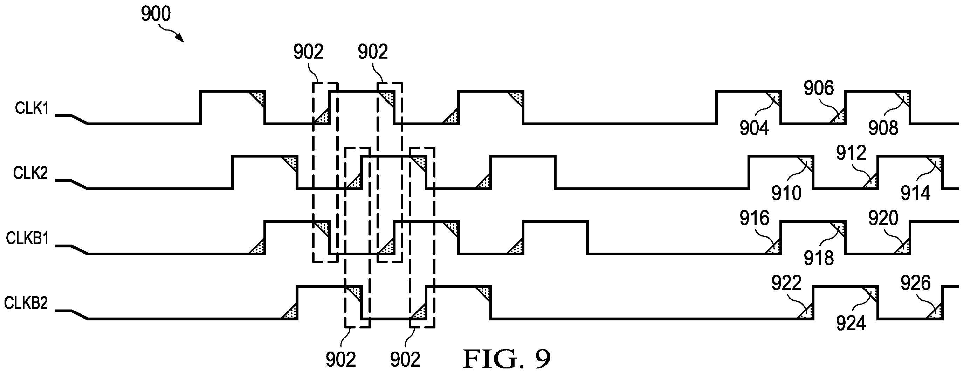

FIG. 9 shows operation of the driver for the LCD. The signals CLK1, CLK2, CLKB1 and CLKB2 correspond to the signals at the pins having the same labels in FIG. 7. As shown in FIG. 9, each signal is 90° out of phase with its immediately preceding signal. Accordingly, the signal CLK2 lags the signal CLK1 by 90°, the signal CLKB1 lags the signal CLK2 by 90°, and the signal CLKB2 lags the signal CLKB1 by 90°. Charge sharing is shown in the rectangles 902. The shaded areas represent the portions of the signal where charge sharing takes place. In the signals on the right side of FIG. 9, charge sharing is shown at 904, 906, 908, 910, 912, 914, 916, 918, 920, 922, 924 and 926.

Modifications are possible in the described embodiments, and other embodiments are possible, within the scope of the claims.

## Claims

1. A level shifter circuit having a plurality of outputs (CLK1, CLKB1, CLK2, CLKB2) for providing signals to respective capacitive loads and having circuits for sharing charge stored in the respective capacitive loads between the outputs, the level shifter circuit comprising:
a first pair of clock generating circuits (M1a, M2a, M1c, M2c) connected to a first pair of outputs (CLK1, CLK2), respectively ;
a second pair of clock generating circuits (M1b, M2b, M1d, M2d) connected to a second pair of outputs (CLKB1, CLKB2), respectively;
a single resistor (Rcs) connectable in the circuit with all of the outputs for controlling a slope of charge sharing between the outputs;
a first switch (M3a) adapted to selectively connect one output of the first pair of outputs (CLK1) directly with a first end (CS1) of the single resistor (Rcs);
a second switch (M3c) adapted to selectively connect the other output of the first pair of outputs (CLK2) directly with the first end (CS1) of the single resistor (Rcs);
**characterized by** further comprising:
a third switch (M3b) adapted to selectively connect one output of the second pair of outputs (CLKB1) directly with a second end (CS2) of the single resistor (Rcs); and
a fourth switch (M3d) adapted to selectively connect the other output of the second pair of outputs (CLKB2) directly with the second end (CS2) of the single resistor (Rcs).

2. The level shifter of claim 1, wherein the clock generating circuits (M1a, M2a, M1b, M2b, M1c, M2c, M1d, M2d) of the first and second pair of clock generating cricuits are identical.

3. The level shifter circuit of claim 1 or 2 wherein the clock generating circuits (M1a, M2a, M1b, M2b, M1c, M2c, M1d, M2d) and switching means (M3a, M3b, M3c, M3d) are on a single integrated circuit and wherein the only component not integrated is the single resistor (Rcs).

4. The level shifter circuit of claim 1, 2 or 3 wherein the number of outputs is 6, 8 or 10.

5. A level shifter according to anyone of claims 1 to 4, wherein the level shifter is for a liquid crystal display, LCD:
wherein the l clock generating circuits (M1a, M2a, M1b, M2b, M1c, M2c, M1d, M2d) are row line control circuits and the outputs are connectable to respective row lines of the LCD; and
wherein the H-type bridge circuit arrangement of the single resistor (Rcs) connected between the row lines enables the slope of charge and discharge voltages on the row lines to be substantially identical.

6. A liquid crystal display (LCD) comprising:
an LCD panel having pixels arranged in rows and columns; and
the level shifter circuit according to claim 5, connected to at least four row lines of the LCD panel, the level shifter being adapted to shift the voltage level of signals generated by a display pattern generator circuit to control the row lines of the LCD panel.

## Patentansprüche

1. Pegelwandlerschaltkreis, der eine Vielzahl von Ausgängen (CLK1, CLKB1, CLK2, CLKB2) zum Bereitstellen von Signalen für entsprechende kapazitive Lasten aufweist und Schaltkreise zum gemeinsamen Nutzen von Ladungen aufweist, die in den entsprechenden kapazitiven Lasten zwischen den Ausgängen gespeichert sind, wobei der Pegelwandlerschaltkreis umfasst:
ein erstes Paar takterzeugender Schaltkreise (M1a, M2a, M1c, M2c), das jeweils mit einem ersten Paar Ausgänge (CLK1, CLK2) verbunden ist;
ein zweites Paar takterzeugender Schaltkreise (M1b, M2b, M1d, M2d), das jeweils mit einem zweiten Paar Ausgänge (CLKB1, CLKB2) verbunden ist;
einen einzigen Widerstand (Rcs), der in dem Schaltkreis an alle Ausgänge anschließbar ist, um eine Flanke des gemeinsamen Nutzens der Ladung durch die Ausgänge zu steuern;
einen ersten Schalter (M3a), der geeignet ist, um einen Ausgang des ersten Paars Ausgänge (CLK1) selektiv direkt mit einem ersten Ende (CS1) des einzigen Widerstands (Rcs) zu verbinden;
einen zweiten Schalter (M3c), der geeignet ist, um den anderen Ausgang des ersten Paars Ausgänge (CLK2) selektiv direkt mit dem ersten Ende (CS1) des einzigen Widerstands (Rcs) zu verbinden;
**dadurch gekennzeichnet, dass** der Pegelwandlerschaltkreis außerdem umfasst:
einen dritten Schalter (M3b), der geeignet ist, um einen Ausgang des zweiten Paars Ausgänge (CLKB1) selektiv direkt mit einem zweiten Ende (CS2) des einzigen Widerstands (Rcs) zu verbinden; und
einen vierten Schalter (M3d), der geeignet ist, um den anderen Ausgang des zweiten Paars Ausgänge (CLKB2) selektiv direkt mit dem zweiten Ende (CS2) des einzigen Widerstands (Rcs) zu verbinden.

2. Pegelwandler nach Anspruch 1, wobei die takterzeugenden Schaltkreise (M1a, M2a, M1b, M2b, M1c, M2c, M1d, M2d) des ersten und des zweiten Paars takterzeugender Schaltkreise identisch sind.

3. Pegelwandlerschaltkreis nach Anspruch 1 oder 2, wobei sich die takterzeugenden Schaltkreise (M1a, M2a, M1b, M2b, M1c, M2c, M1d, M2d) und Schaltelemente (M3a, M3b, M3c, M3d) in einem einzigen integrierten Schaltkreis befinden und wobei die einzige nicht integrierte Komponente der einzige Widerstand (Rcs) ist.

4. Pegelwandlerschaltkreis nach Anspruch 1, 2 oder 3, wobei die Anzahl von Ausgängen 6, 8 oder 10 beträgt.

5. Pegelwandler nach einem der Ansprüche 1 bis 4, wobei der Pegelwandler für eine Flüssigkristallanzeige (Liquid Crystal Display, LCD) vorgesehen ist;
wobei die I takterzeugenden Schaltkreise (M1a, M2a, M1b, M2b, M1c, M2c, M1d, M2d) Reihenleitungssteuerschaltkreise sind und die Ausgänge an entsprechende Reihenleitungen der LCD anschließbar sind; und
wobei die H-Typ-Brückenschaltkreisanordnung des einzigen Widerstands (Rcs), der zwischen die Reihenleitungen geschaltet ist, ermöglicht, dass die Flanke des Ladens und Entladens der Spannungen an den Reihenleitungen im Wesentlichen identisch ist.

6. Flüssigkristallanzeige (Liquid Crystal Display, LCD), umfassend:
eine LCD-Fläche, die Pixel aufweist, die in Reihen und Spalten angeordnet sind; und
den Pegelwandlerschaltkreis nach Anspruch 5, der mit mindestens vier Reihenleitungen der LCD-Fläche verbunden ist, wobei der Pegelwandler geeignet ist, den Spannungspegel von Signalen zu wandeln, die durch einen Anzeigemustererzeugerschaltkreis erzeugt werden, um die Reihenleitungen der LCD-Fläche zu steuern.

## Revendications

1. Circuit décaleur de niveau ayant une pluralité de sorties (CLK1, CLKB1, CLK2, CLKB2) destinées à fournir des signaux à des charges capacitives respectives et ayant des circuits destinés à partager une charge stockée dans les charges capacitives respectives entre les sorties, le circuit décaleur de niveau comprenant :
une première paire de circuits de génération d'horloge (M1a, M2a, M1c, M2c) raccordés à une première paire de sorties (CLK1, CLK2), respectivement ;
une deuxième paire de circuits de génération d'horloge (M1b, M2b, M1d, M2d) raccordés à une deuxième paire de sorties (CLKB1, CLKB2), respectivement ;
une unique résistance (Rcs) raccordable dans le circuit à toutes les sorties pour commander une pente de partage de charge entre les sorties ;
un premier commutateur (M3a) adapté pour raccorder sélectivement une sortie de la première paire de sorties (CLK1) directement à une première extrémité (CS1) de l'unique résistance (Rcs) ;
un deuxième commutateur (M3c) adapté pour raccorder sélectivement l'autre sortie de la première paire de sorties (CLK2) directement à la première extrémité (CS1) de l'unique résistance (Rcs) ;
**caractérisé en ce qu'**il comprend en outre :
un troisième commutateur (M3b) adapté pour raccorder sélectivement une sortie de la deuxième paire de sorties (CLKB1) directement à une deuxième extrémité (CS2) de l'unique résistance (Rcs) ; et
un quatrième commutateur (M3d) adapté pour raccorder sélectivement l'autre sortie de la deuxième paire de sorties (CLKB2) directement à la deuxième extrémité (CS2) de l'unique résistance (Rcs).

2. Décaleur de niveau de la revendication 1, dans lequel les circuits de génération d'horloge (M1a, M2a, M1b, M2b, M1c, M2c, M1d, M2d) de la première et la deuxième paire de circuits de génération d'horloge sont identiques.

3. Circuit décaleur de niveau de la revendication 1 ou 2 dans lequel les circuits de génération d'horloge (M1a, M2a, M1b, M2b, M1c, M2c, M1d, M2d) et les moyens de commutation (M3a, M3b, M3c, M3d) sont sur un unique circuit intégré et dans lequel l'unique composant non intégré est l'unique résistance (Rcs).

4. Circuit décaleur de niveau de la revendication 1, 2 ou 3 dans lequel le nombre de sorties est de 6, 8 ou 10.

5. Décaleur de niveau selon l'une quelconque des revendications 1 à 4, le décaleur de niveau étant destiné à un écran à cristaux liquides, LCD :
dans lequel les circuits de génération d'horloge (M1a, M2a, M1b, M2b, M1c, M2c, M1d, M2d) sont des circuits de commande de ligne de rangée et les sorties sont raccordables à des lignes de rangée respectives du LCD ; et
dans lequel l'agencement de circuit de pontage de type H de l'unique résistance (Rcs) raccordé entre les lignes de rangée permet aux pentes des tensions de charge et de décharge sur les lignes de rangée d'être sensiblement identiques.

6. Écran à cristaux liquides (LCD) comprenant :
un panneau LCD ayant des pixels disposés dans des rangées et des colonnes ; et
le circuit décaleur de niveau selon la revendication 5, raccordé à au moins quatre lignes de rangée du panneau LCD, le décaleur de niveau étant adapté pour décaler le niveau de tension de signaux générés par un circuit générateur de motifs d'affichage pour commander les lignes de rangée du panneau LCD.
